(19) **Europäisches Patentamt**

**European Patent Office**

**Office européen des brevets**

(11) **EP 1 194 785 B1**

(12) **EUROPÄISCHE PATENTSCHRIFT**

(45) Veröffentlichungstag und Bekanntmachung des Hinweises auf die Patenterteilung:
**22.01.2003 Patentblatt 2003/04**

(21) Anmeldenummer: **00958168.7**

(22) Anmeldetag: **19.07.2000**

(51) Int Cl.$^7$: **G01R 19/25**

(86) Internationale Anmeldenummer:
**PCT/DE00/02434**

(87) Internationale Veröffentlichungsnummer:
**WO 01/006265 (25.01.2001 Gazette 2001/04)**

(54) **VERFAHREN ZUM ERMITTELN VON AMPLITUDE UND PHASENWINKEL EINES EINEM STROM ODER EINER SPANNUNG EINES ELEKTRISCHEN ENERGIEVERSORGUNGSNETZES ENTSPRECHENDEN MESSSIGNALS**

METHOD FOR DETERMINING THE AMPLITUDE AND ANGLE OF PHASE OF A MEASURING SIGNAL CORRESPONDING TO THE CURRENT OR VOLTAGE OF AN ELECTRIC POWER DISTRIBUTION SYSTEM

PROCEDE DE DETERMINATION DE L'AMPLITUDE ET DE L'ANGLE DE PHASE D'UN SIGNAL DE MESURE CORRESPONDANT AU COURANT OU A LA TENSION D'UN RESEAU ELECTRIQUE DE DISTRIBUTION D'ENERGIE

(84) Benannte Vertragsstaaten:
**DE FR GB IT**

(30) Priorität: **19.07.1999 DE 19934055**

(43) Veröffentlichungstag der Anmeldung:
**10.04.2002 Patentblatt 2002/15**

(73) Patentinhaber: **SIEMENS AKTIENGESELLSCHAFT 80333 München (DE)**

(72) Erfinder:
• **JURISCH, Andreas**
  **D-16727 Schwante (DE)**

• **KRAMER, Dieter**
  **D-01279 Dresden (DE)**

(56) Entgegenhaltungen:
**DE-C- 4 205 300           DE-C- 4 211 946**
**US-A- 5 729 465**

• **SACHDEV ET AL.: "a recursive least error squares algorithm" IEEE TRANS. ON POWER DELIVERY, Bd. 6, Nr. 3, Juli 1991 (1991-07), Seiten 1008-1015, XP000978300 in der Anmeldung erwähnt**

EP 1 194 785 B1

**Beschreibung**

Die Erfindung betrifft ein Verfahren zum Ermitteln von Amplitude und Phasenwinkel eines einem Strom oder einer Spannung an einem elektrischen Energieversorgungsnetz entsprechenden Meßsignals mit Abtastwerten des Meßsignals, wobei mit den Abtastwerten anhand eines mindestens einen sinusförmigen Anteil enthaltenden Modells für das Meßsignal unter Anwendung eines rekursiven least-squares-Schätzverfahrens der Modell-Parameter Amplitude und der Modell-Parameter Phase des Meßsignals errechnet werden.

Ein derartiges Verfahren ist in einem Aufsatz von M.S. Sachdev und M. Nagpal "A recursive least squares error algorithm for power system relaying and measurement applications", IEEE Trans. on Power Delivery, Vol. 6, No. 3, July 1991 beschrieben. Bei diesem bekannten Verfahren werden aus einem einem Strom oder einer Spannung eines elektrischen Energieversorgungsnetzes entsprechenden Meßsignal Abtastwerte gebildet und daraus mittels eines linearen least-squares-Schätzverfahrens unter Benutzung eines das Meßsignal modellierenden sinusförmigen Signalmodells ein komplexer Zeiger gebildet, der Amplitude und Phasenwinkel des Meßsignals angibt. Dabei werden in einem ersten Schritt Real- und Imaginärteil des Zeigers jeweils für sich ermittelt. Aus dem Real- und Imaginärteil des Zeigers kann in einem zweiten Schritt mittels einer Koordinatentransformation die Polarkoordinatendarstellung des komplexen Zeigers, d. h. Betrag und Phase des Zeigers, ermittelt werden.

Bei dem bekannten Verfahren wird davon ausgegangen, daß die Frequenz des Meßsignals bekannt ist. Ist dies nicht der Fall oder verändert sich die Frequenz, dann wird zur Ermittlung der Frequenz des Meßsignals ein getrenntes Verfahren benötigt. Bekannt sind da beispielsweise Verfahren, die den Abstand der Nulldurchgänge des Meßsignals ausmessen und auf Basis dieser Periodendauermessung die Frequenz des Meßsignals ermitteln, siehe z.B. E. Schrüfer (Hrsg.): "Lexikon Meß- und Automatisierungstechnik", VDI-Verlag, 1992, S.204. Weiterhin ist ein Verfahren zur Frequenzmessung bekannt, bei dem das zu untersuchende Meßsignal parallel jeweils mit einem Hochpaß und einem Allpaß gefiltert wird (Deutsche Patentschrift DE 42 11 946). Über das Verhältnis der Amplituden der Ausgangssignale dieser beiden Filter kann die Frequenz des Meßsignals bestimmt werden.

Der Erfindung liegt die Aufgabe zugrunde, ein Verfahren anzugeben, mit dem gleichzeitig und schnell alle signifikanten Größen des Meßsignals ermittelt werden können.

Diese Aufgabe wird bei einem Verfahren der eingangs angegebenen Art erfindungsgemäß dadurch gelöst, daß ein aus dem sinusförmigen Anteil bestehendes Modell für das Meßsignal gemäß der Beziehung $y = A \cdot \sin(2\pi f t + \varphi)$ verwendet wird, wobei y einen Momentanwert des Modells für das Meßsignal, A die Amplitude, f die Frequenz, $\varphi$ den Phasenwinkel und t die Zeit bezeichnet; mit diesem Modell für das Meßsignal und mit den Abtastwerten wird mittels eines rekursiven nichtlinearen least-squares-Schätzverfahrens gemeinsam mit dem Modell-Parameter Amplitude und dem Modell-Parameter Phasenwinkel auch der Modell-Parameter Frequenz des Meßsignals durch die Schätzung bestimmt.

Es ist zwar aus dem Buch von H.-J. Hermann "Digitale Schutztechnik", 1997, S. 110-111 bekannt, in der Schutztechnik ein rekursives, nichtlineares least-squares-Schätzverfahren einzusetzen, jedoch enthält das Buch keinen Hinweis darauf, daß mit einem solchen Schätzverfahren aus Abtastwerten eines Meßsignals in einem einzigen Meßwertverarbeitungsprozeß Amplitude, Phasenwinkel und Frequenz des Meßsignals bestimmbar sind.

Ein wesentlicher Vorteil des erfindungsgemäßen Verfahrens besteht jedoch gerade darin, daß aus den Abtastwerten des Meßsignals außer Amplitude und Phasenwinkel in einem Meßwertverarbeitungsprozeß auch die Frequenz ermittelt wird und somit Amplitude, Phasenwinkel und Frequenz des Meßsignals demselben Zeitpunkt zugeordnet sind.

Weiterhin ist aus der Patentschrift DE 42 05 300 C1 ein Verfahren bekannt, mit dem die Phasenlage und die Amplitude eines periodischen Signals über eine phasenstarre Regelschleife (PLL (Phase-Locked Loop)) ermittelt werden kann.

Die Verwendung des Modells für das Meßsignal
$y = A \cdot \sin(2\pi f t + \varphi)$ führt zu guten Ergebnissen, wenn das Meßsignal einen rein sinusförmigen Verlauf hat. Ist in dem Meßsignal ein Gleichanteil vorhanden, wird vorteilhafterweise ein Modell für das Meßsignal gemäß der Beziehung $y = A \cdot \sin(2\pi f t + \varphi) + d$ verwendet, wobei der Summand d den Gleichanteil des Meßsignals modelliert.

Handelt es sich bei dem Meßsignal um ein Signal, dessen Frequenz sich mit der Zeit ändert, dann kann vorteilhafterweise bei solchen Meßsignalen ohne Gleichanteil ein Modell für das Meßsignal gemäß der Beziehung

$$y = A \cdot \sin\left(2\pi \sum_{i=0}^{n}(f^{(i)}t^{i})t + \varphi\right)$$

und bei Meßsignalen mit Gleichanteil ein Modell für das Meßsignal gemäß der Beziehung

$$y = A \cdot \sin\left(2\pi \sum_{i=0}^{n} (f^{(i)}t^i)t + \varphi\right) + d$$

verwendet werden, wobei $f^{(i)}$ die Ableitung i-ter Ordnung der Frequenz nach der Zeit bezeichnet und eine Frequenzänderung über der Zeit modelliert und durch Wahl der Größe n verschiedene Ordnungen der Ableitung der Frequenz nach der Zeit berücksichtigt werden. Bei diesen Modellen wird in Fortbildung des oben angegebenen Modells $y = A \cdot \sin(2\pi ft + \varphi)$ die Frequenz f durch den Ausdruck

$$\sum_{i=0}^{n} (f^{(i)}t^i)$$

ersetzt; bei Berücksichtigung nur einer Ableitung 0-ter Ordnung wird der Summenausdruck zu $f^{(0)}$ bzw. f. Diese erweiterten Modelle ermöglichen es, neben den Größen Amplitude A, Phasenwinkel $\varphi$ und Frequenz f auch Frequenzänderungen $f^{(i)}$ über der Zeit zu ermitteln.

In einer weiteren vorteilhaften Ausgestaltung des erfindungsgemäßen Verfahrens werden die durch das Schätzverfahren ermittelten Werte der Amplitude A, des Phasenwinkels $\varphi$ und der Frequenz f erst dann als Ergebnis ausgegeben, wenn der Schätzfehler kleiner ist als ein kleinster zugelassener Schätzfehler. Dies hat den Vorteil, daß insbesondere die zu Beginn des Verfahrens geschätzten, mit großen Schätzfehlern behafteten Werte nicht ausgegeben werden und somit die großen Schätzfehler für einen Benutzer des Verfahrens keine negativen Folgen haben können.

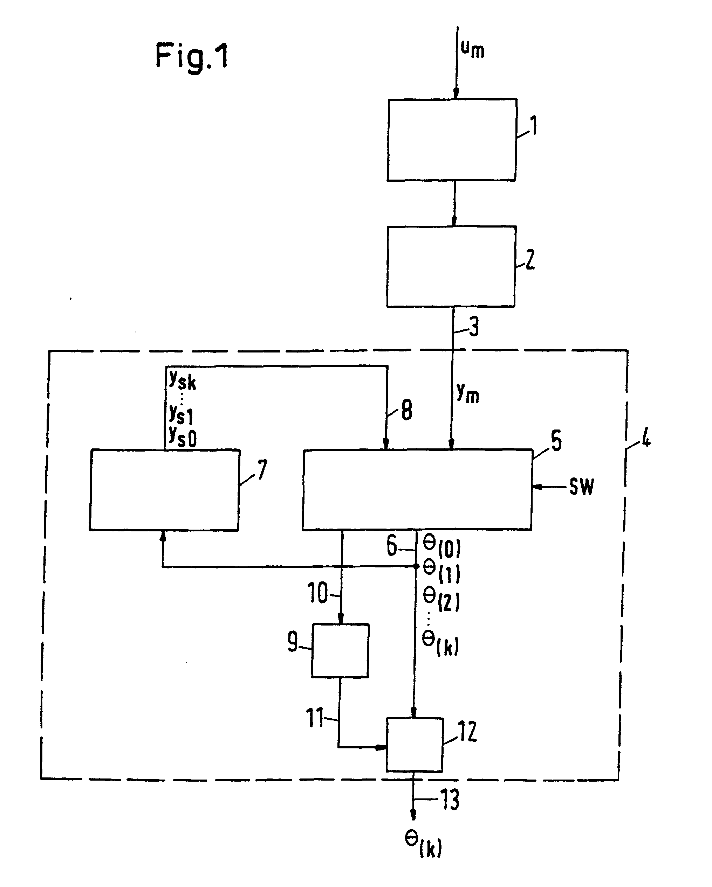

Zur weiteren Erläuterung der Erfindung sind in Figur 1 anhand eines Blockschaltbildes der Ablauf eines Ausführungsbeispiels des erfindungsgemäßen Verfahrens, in

Figur 2 Verläufe eines Meßsignals, eines mit einem Modell $y = A \cdot \sin(2\pi ft + \varphi)$ für das Meßsignal ermittelten Schätzsignals $y_s$ und des sich ergebenden Fehler F, in

Figur 3 Ergebnisse des erfindungsgemäßen Verfahrens bei einem rein sinusförmigen Meßsignal bei Verwendung eines entsprechenden Modells für das Meßsignal getrennt nach den zeitlichen Verläufen von Amplitude, Phasenwinkel und Frequenz, in

Figur 4 Ergebnisse des erfindungsgemäßen Verfahrens bei einem offsetbehafteten, d. h. einen Gleichanteil enthaltenden Meßsignal getrennt nach den zeitlichen Verläufen von Amplitude, Phasenwinkel und Frequenz bei Verwendung eines keinen Gleichanteil modellierenden Modells für das Meßsignal, und in

Figur 5 Ergebnisse des erfindungsgemäßen Verfahrens bei einem offsetbehafteten, d. h. einen Gleichanteil enthaltenden Meßsignal getrennt nach den zeitlichen Verläufen von Amplitude, Phasenwinkel, Frequenz und Gleichanteil bei Verwendung eines einen Gleichanteil modellierenden Modells für das Meßsignal gezeigt.

Gemäß Figur 1 liegen Abtastwerte $y_m$ eines Meßsignals um nach Abtastung in einer Abtast-Halte-Schaltung 1 und Analog-Digital-Umsetzung in einem Analog-Digital-Umsetzer 2 an einem Eingang 3 einer Datenverarbeitungsanlage 4. Die Datenverarbeitungsanlage 4 beinhaltet eine Einheit 5 zur Durchführung eines rekursiven nichtlinearen least-squares-Schätzverfahrens. Zu Beginn des rekursiven Schätzverfahrens werden für die Größen Amplitude A, Frequenz f und Phasenwinkel $\varphi$ Startwerte SW in die Einheit 5 eingegeben und liegen am Ausgang 6 der Einheit 5 als Schätzungsausgangswerte $\underline{\Theta}_{(0)}$. Die Schätzungsausgangswerte $\underline{\Theta}_{(0)}$ werden zu einem Block 7 geleitet, der ein Modell für das Meßsignal beinhaltet.

Im Block 7 wird aus den Schätzungsausgangswerten $\underline{\Theta}_{(0)}$ unter Berücksichtigung des Modells für das Meßsignal ein Startsignalwert $y_{s0}$ ermittelt, der am Ausgang des Blockes 7 ausgegeben und auf einen Eingang 8 der Einheit 5 geführt wird.

Die Einheit 5 ermittelt aus einem (ersten) Abtastwert $y_m$ des Meßsignals $u_m$ und dem Startsignalwert $y_{s0}$ einen Schätzfehler $F_{schätz}$ gemäß der untengenannten Beziehung (3). Dieser Schätzfehler wird oberhalb eines zugelassenen kleinsten Schätzfehlers liegen. Deshalb werden in der Einheit 5 ausgehend von den Schätzungsausgangswerten $\underline{\Theta}_{(0)}$ nach den Regeln für rekursive nichtlineare least-squares-Schätzungen entsprechend der untenstehenden Beziehung (1) neue Schätzungswerte $\underline{\Theta}_{(1)}$ gebildet, am Ausgang 6 der Einheit 5 ausgegeben und zu Block 7 geleitet.

In Block 7 wird aus den neuen Schätzungswerten $\underline{\Theta}_{(1)}$ ein Schätzsignalwert $y_{s1}$ ermittelt, der am Ausgang des Blockes 7 ausgegeben und auf den Eingang 8 der Einheit 5 geführt wird. Die Einheit 5 ermittelt aus den (ersten beiden) Abtastwerten $y_m$ und dem Startsignalwert $y_{so}$ und dem Schätzsignalwert $y_{s1}$ wiederum einen Schätzfehler $F_{schätz}$ nach der untengenannten Beziehung (3). Auch dieser Schätzfehler wird im allgemeinen oberhalb des kleinsten zugelassenen Schätzfehlers liegen. Deshalb werden in der Einheit 5 ausgehend von den Schätzungswerten $\underline{\Theta}_{(1)}$ der vergangenen Schätzung nach der Beziehung (1) wieder neue Schätzwerte $\underline{\Theta}_{(2)}$ ermittelt. Diese Schritte werden solange wiederholt, bis der Schätzfehler $F_{schätz}$ unterhalb eines kleinsten zugelassenen Schätzfehlers liegt.

Zur Feststellung, ob der Schätzfehler $F_{schätz}$ unterhalb eines kleinsten zugelassenen Schätzfehlers liegt, wird ein Block 9 genutzt. Block 9 erhält über einen Eingang 10 von der Einheit 5 die Abtastwerte $y_m$ des Meßsignals $u_m$, den Startsignalwert $y_{so}$ und die Schätzsignalwerte $y_{s1}$ bis $y_{sk}$, welche in der Einheit 5 zwischengespeichert sind. Wenn der Schätzfehler $F_{schätz}$ unterhalb eines kleinsten zugelassenen Schätzfehlers liegt, dann wird an einem Ausgang 11 des Blocks 9 ein Schaltsignal ausgegeben, welches einen Schalter 12 durchschaltet. Der Schalter 12 leitet die dann am Ausgang 6 der Einheit 5 vorliegenden Schätzungswerte $\underline{\Theta}_{(k)}$ an einen Ausgang 13 der Datenverarbeitungsanlage 4 weiter. Die Schätzungswerte $\underline{\Theta}_{(k)}$ werden dann als Ergebniswerte des Schätzverfahrens ausgegeben und stellen die mit einer hinreichenden Genauigkeit geschätzten Werte für Amplitude, Frequenz und Phasenwinkel des Meßsignals dar. Das Schätzverfahren läuft danach wie oben beschrieben weiter und ermöglicht eine kontinuierliche Ermittlung der Schätzungswerte $\underline{\Theta}_{(k)}$.

Die Einheit 5 ermittelt die Schätzungswerte $\underline{\Theta}_{(k)}$ entsprechend der folgenden Beziehung (1).

$$\underline{\Theta}_{(k)} = \underline{\Theta}_{(k-1)} + \underline{P}_{(k)}\underline{\gamma}_{(k)}\left(y_{(k)} - h\left(\underline{\varphi}_{(k)}, \underline{\Theta}_{(k-1)}\right)\right) \tag{1}$$

In der Beziehung (1) stellt $\underline{\Theta}_{(k)}$ einen Vektor dar, der die Schätzungswerte der zu bestimmenden Größen, hier also Amplitude A, Frequenz f und Phasenwinkel $\varphi$, nach k Schätzschritten enthält; mit $\underline{\Theta}_{(k-1)}$ ist ein Vektor bezeichnet, der sich bei der Schätzung nach k-1 Schätzschritten ergibt. Die Matrix $\underline{P}_{(k)}$ ist eine sogenannte symmetrische Präzisionsmatrix, deren Ermittlung weiter unten anhand der Beziehung (2) dargestellt ist. Die Funktion

$$h\left(\underline{\varphi}_{(k)}, \underline{\Theta}_{(k-1)}\right)$$

beinhaltet das Modell für das Meßsignal. Der Vektor $\underline{\gamma}_{(k)}$ enthält die partiellen Ableitungen des Modells

$$h\left(\underline{\varphi}_{(k)}, \underline{\Theta}_{(k-1)}\right)$$

für das Meßsignal nach den Parametern des Modells für das Meßsignal, d.h. Ableitungen nach Amplitude, Phasenwinkel und Frequenz. Die Größe $y_{(k)}$ ist der k-te Abtastwert des Meßsignals.

Zur Bestimmung der Präzisionsmatrix $\underline{P}_{(k)}$ wird eine Beziehung (2) angewandt.

$$\underline{P}_{(k)} = \frac{1}{\lambda}\left(\underline{P}_{(k-1)} - \frac{\underline{P}_{(k-1)} \cdot \underline{\gamma}_{(k)}}{\lambda + \underline{\gamma}_{(k)}^{T}\underline{P}_{(k-1)}\underline{\gamma}_{(k)}} \cdot \underline{\gamma}_{(k)}^{T}\underline{P}_{(k-1)}\right) \tag{2}$$

Der Faktor $\lambda$ bestimmt die exponentielle Wichtung vergangener Abtastwerte des Meßsignals. Zu Beginn des Verfahrens wird für die Präzisionsmatrix $\underline{P}_{(k)}$ ein Startwert verwendet.

Der Schätzfehler $F_{schätz}$ nach der k-ten Schätzung wird mittels der Beziehung

$$F_{schätz} = \frac{1}{N}\sum_{i=k-N+1}^{k}(y_{mi} - y_{si})^2 \tag{3}$$

ermittelt. Dabei ist N die Anzahl der zu berücksichtigenden Abtastwerte $y_m$ des Meßsignals $u_m$ und der zu berücksichtigenden Schätzsignalwerte $y_s$, $y_{mi}$ der i-te Abtastwert des Meßsignals $u_m$ und $y_{si}$ der i-te Schätzsignalwert.

Der Schätzfehler $F_{schätz}$ wird ermittelt, indem N Abtastwerte $y_{mi}$ des Meßsignals $u_m$ und N Schätzsignalwerte $y_{si}$ ausgewertet werden. Eine sinnvolle Größe für N ist der Quotient (Abtastfrequenz der Abtast-Halte-Schaltung 1) / (geschätzte Frequenz), N kann jedoch auch größer gewählt werden. Beim ersten Schätzungsdurchlauf wird für N der Quotient (Abtastfrequenz der Abtast-Halte-Schaltung 1) / (Startwert SW der Frequenz) benutzt. Wenn zu Beginn des Schätzverfahrens noch nicht N Abtastwerte $y_{mi}$ des Meßsignals $u_m$ bzw. N Schätzsignalwerte $y_{si}$ vorliegen, so werden nur die vorliegenden Werte zur Bestimmung des Schätzfehlers $F_{schätz}$ benutzt.

Weitere Einzelheiten zur Durchführung rekursiver nichtlinearer least-squares-Schätzverfahren sind in den Druckschriften J. Wede; D. Werner: "Echtzeitprozeßmodelle auf der Basis von Parameterschätzverfahren", Reihe Automatisierungstechnik, Band 214, VEB Verlag Technik, Berlin, 1985, S. 30 - 34, S. 44 - 50, 56, 57 und Hans-Joachim Herrmann: "Digitale Schutztechnik: Grundlagen, Software, Ausführungsbeispiele", VDE-Verlag 1997, S. 104 - 113 bzw. A. Jurisch: "Digitale Impedanzmeßverfahren auf der Basis von Identifikationsmethoden", Dissertation, Technische Hochschule Zittau, 1990, Beilage 4.6.3 beschrieben.

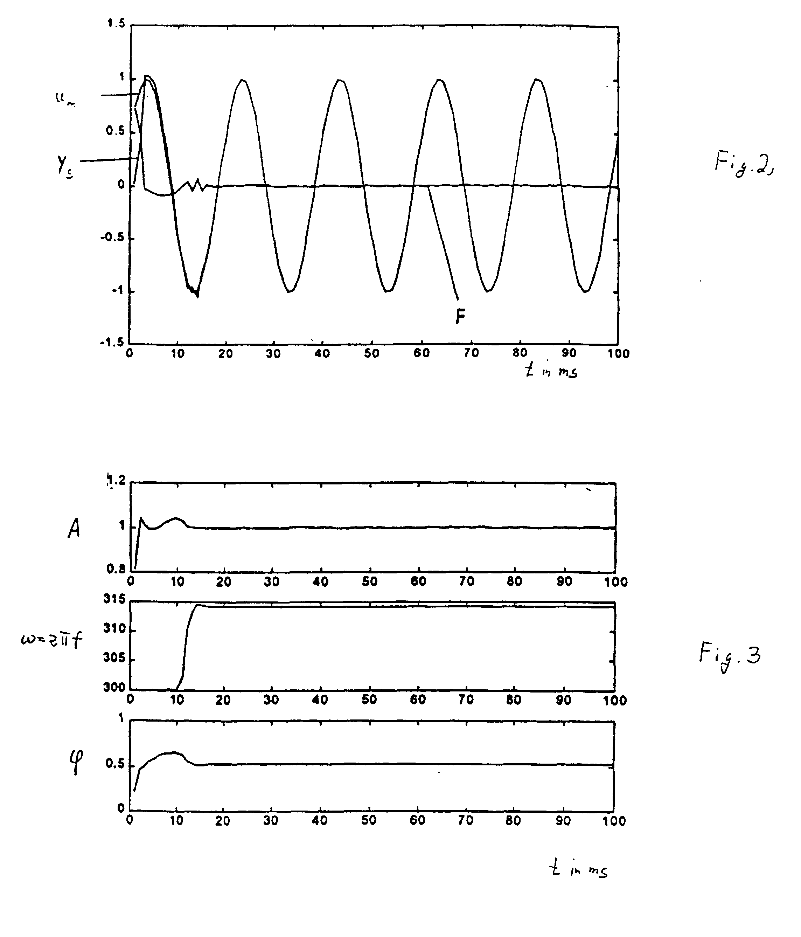

Figur 2 zeigt den zeitlichen Verlauf eines sinusförmigen Meßsignals $u_m$, dessen Amplitude, Frequenz und Phasenwinkel mit dem Schätzverfahren gemäß Figur 1 zu ermitteln sind. Desweiteren sind als Kurve $y_s$ die Schätzsignalwerte $y_{s1}$ ... $y_{sk}$ über der Zeit gezeigt, die am Ausgang des Blockes 7 ausgegeben werden. Ebenso ist der Verlauf der Werte des Fehlers F, welcher sich aus der Differenz zwischen dem Meßsignal $u_m$ und den Schätzsignalwerten $y_{s1}$ ... $y_{sk}$ ergibt, über der Zeit t dargestellt. Die gezeigten Verläufe ergeben sich bei einem Schätzverfahren, das mit dem Modell $y = A \cdot \sin(2\pi f t + \varphi)$ für das Meßsignal durchgeführt wurde. Es ist zu erkennen, daß der Verlauf der Kurve $y_s$ mit dem Verlauf des Meßsignals $u_m$ nach ca. 20 ms übereinstimmt; der Fehler F nimmt dann sehr kleine Werte an. Das Schätzverfahren ermöglicht also nach ca. einer Periodendauer des Meßsignals $u_m$ die korrekte Bestimmung der Amplitude, der Frequenz und des Phasenwinkels des Meßsignals.

In der Figur 3 sind unter Berücksichtigung der in Figur 2 gezeigten Verläufe die mit den Schätzsignalwerten $y_{s1}$ ... $y_{sk}$ verknüpften Schätzungswerte $\underline{\Theta}_{(1)}$ ... $\underline{\Theta}_{(k)}$ über der Zeit t getrennt nach den sie bestimmenden Größen A, ω bzw. 2πf und φ aufgetragen. Figur 3 zeigt in einem oberen Diagramm den mit dem Schätzverfahren gemäß Figur 1 ermittelten Verlauf der Amplitude A, in einem mittleren Diagramm den Verlauf der der Frequenz f proportionalen Größe ω = 2πf und in einem unteren Diagramm den Verlauf des Phasenwinkels φ jeweils über der Zeit aufgetragen. Entsprechend Figur 2 ergibt sich, daß die zeitlichen Verläufe nach ca. 20 ms auf ihren Endwert bei kleinstem zugelassenen Schätzfehler eingeschwungen sind und das Ergebnis des Schätzverfahrens anzeigen.

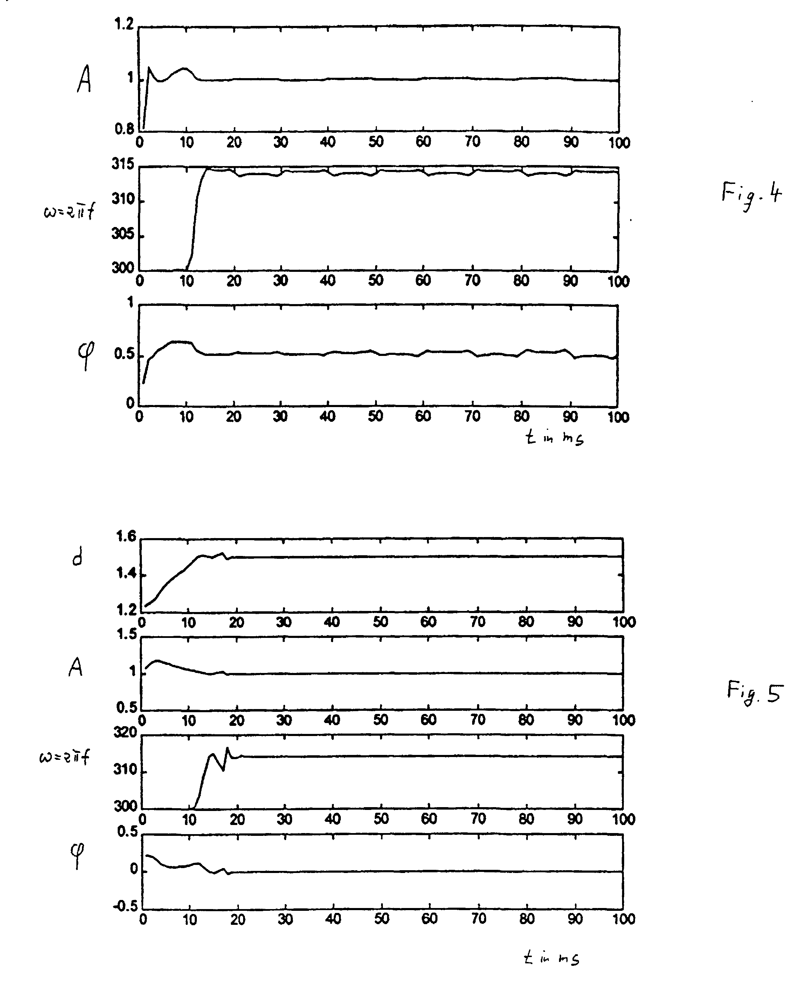

Figur 4 zeigt in einer mit Figur 3 übereinstimmenden Darstellungsart die in einer weiteren Schätzung mit dem Modell für das Meßsignal $y = A \cdot \sin(2\pi f t + \varphi)$ ermittelten zeitlichen Verläufe von Amplitude A, Frequenz f und Phasenwinkel φ, wenn Abtastwerte eines Meßsignals verwendet werden, das einen Gleichanteil enthält. In den Verläufen von Frequenz und Phasenwinkel sind auch für Zeiten größer als 20 ms starke zeitliche Schwankungen enthalten. Diese Schwankungen weisen auf eine fehlerbehaftete Schätzung hin und sind ein Hinweis darauf, daß das gewählte Modell für ein einen Gleichanteil enthaltendes Meßsignal ungünstig ist.

Figur 5 zeigt die in einer Schätzung mit dem Modell y = A · sin(2πft + φ) + d für das Meßsignal ermittelten zeitlichen Verläufe von Amplitude A, Frequenz f, Phasenwinkel φ und Gleichanteil d, wenn Abtastwerte eines Meßsignals verwendet werden, das einen Gleichanteil enthält. Durch Nutzung des eben genannten Modells für das Meßsignal werden Schwankungen in den zeitlichen Verläufen von Frequenz und Phasenwinkel vermieden; es wird folglich eine im Hinblick auf den Schätzfehler bessere Schätzung durchgeführt.

## Patentansprüche

1. Verfahren zum Ermitteln von Amplitude und Phasenwinkel eines einem Strom oder einer Spannung an einem elektrischen Energieversorgungsnetz entsprechenden Meßsignals mit Abtastwerten des Meßsignals, wobei mit den Abtastwerten anhand eines mindestens einen sinusförmigen Anteil enthaltenden Modells für das Meßsignal unter Anwendung eines rekursiven least-squares-Schätzverfahrens der Modell-Parameter Amplitude und der Modell-Parameter Phase des Meßsignals errechnet werden,
   **dadurch gekennzeichnet, daß**

   - ein aus dem sinusförmigen Anteil bestehendes Modell für das Meßsignal gemäß der Beziehung $y = A \cdot \sin(2\pi f t + \varphi)$ verwendet wird, wobei y einen Momentanwert des Modells für das Meßsignal, A die Amplitude, f die Frequenz, φ den Phasenwinkel und t die Zeit bezeichnet, und
   - mit diesem Modell für das Meßsignal und mit den Abtastwerten mittels eines rekursiven nichtlinearen least-squares-Schätzverfahrens gemeinsam mit dem Modell-Parameter Amplitude (A) und dem Modell-Parameter Phasenwinkel (φ) auch der Modell-Parameter Frequenz (f) des Meßsignals durch die Schätzung bestimmt wird.

2. Verfahren nach Anspruch 1,
   **dadurch gekennzeichnet, daß**

ein Modell für das Meßsignal gemäß der Beziehung $y = A \cdot \sin(2\pi ft + \varphi) + d$ verwendet wird, wobei d den Gleichanteil des Meßsignals modelliert.

**3.** Verfahren nach Anspruch 1,
**dadurch gekennzeichnet, daß**
ein Modell für das Meßsignal gemäß der Beziehung

$$y = A \cdot \sin\left(2\pi\sum_{i=0}^{n}(f^{(i)}t^{i})t + \varphi\right)$$

verwendet wird, wobei $f^{(i)}$ die Ableitung i-ter Ordnung der Frequenz nach der Zeit bezeichnet und eine Frequenzänderung über der Zeit modelliert und durch Wahl der Größe n verschiedene Ordnungen der Ableitung der Frequenz nach der Zeit berücksichtigt werden.

**4.** Verfahren nach Anspruch 2,
**dadurch gekennzeichnet, daß**
ein Modell für das Meßsignal gemäß der Beziehung

$$y = A \cdot \sin\left(2\pi\sum_{i=0}^{n}(f^{(i)}t^{i})t + \varphi\right) + d$$

verwendet wird, wobei $f^{(i)}$ die Ableitung i-ter Ordnung der Frequenz nach der Zeit bezeichnet und eine Frequenzänderung über der Zeit modelliert und durch Wahl der Größe n verschiedene Ordnungen der Ableitung der Frequenz nach der Zeit berücksichtigt werden.

**5.** Verfahren nach einem der Ansprüche 1 bis 4,
**dadurch gekennzeichnet, daß**
die durch das Schätzverfahren ermittelten Werte der Amplitude (A), des Phasenwinkels ($\varphi$) und der Frequenz (f) erst dann als Ergebniswerte ausgegeben werden, wenn der Schätzfehler kleiner ist als ein kleinster zugelassener Schätzfehler.

**Claims**

**1.** Method for determining the amplitude and phase angle of a measuring signal corresponding to a current or a voltage on an electrical power supply network by using sampled values of the measuring signal, a model of the measuring signal containing at least a sinusoidal component being used to calculate the model amplitude and phase parameters of the measuring signal with the sampled values by applying a recursive least-squares estimation method, **characterized in that**

- use is made of a model of the measuring signal containing the sinusoidal component in accordance with the relationship $y = A \cdot \sin(2\pi ft + \varphi)$, y designating an instantaneous value of the model of the measuring signal, A the amplitude, f the frequency, $\varphi$ the phase angle and t the time, and
- by using this model of the measuring signal and by using the sampled values, by means of a recursive nonlinear least-squares estimation method, the model frequency parameter (f) of the measuring signal is also determined by the estimation together with the model amplitude parameter (A) and the model phase angle parameter ($\varphi$).

**2.** Method according to Claim 1, **characterized in that** use is made of a model for the measuring signal in accordance with the relationship $y = A \cdot \sin(2\pi ft + \varphi) + d$, d modelling the DC component of the measuring signal.

**3.** Method according to Claim 1, **characterized in that** use is made of a model for the measuring signal in accordance with the relationship

$$y = A \cdot \sin\left(2\pi \sum_{i=0}^{n} (f^{(i)} t^{i}) t + \varphi\right),$$

$f^{(i)}$ designating the ith order time derivative of the frequency and modelling a change in the frequency over time, and various orders of the time derivative of the frequency being taken into account by selecting the variable n.

4.  Method according to Claim 2, **characterized in that** use is made of a model of the measuring signal in accordance with the relationship

$$y = A \cdot \sin\left(2\pi \sum_{i=0}^{n} (f^{(i)} t^{i}) t + \varphi\right) + d,$$

$f^{(i)}$ designating the ith time derivative of the frequency and modelling a change in the frequency over time, and various orders of the time derivative of the frequency being taken into account by selecting the variable n.

5.  Method according to one of Claims 1 to 4, **characterized in that** the values of the amplitude (A), the phase angle (φ) and the frequency (f) determined by the estimation method are output as resulting values only when the estimation error is less than a smallest permitted estimation error.

**Revendications**

1.  Procédé pour déterminer l'amplitude et l'angle de phase d'un signal de mesure correspondant à un courant ou à une tension sur un réseau d'alimentation en énergie électrique avec des valeurs échantillonnées du signal de mesure, le paramètre de modèle amplitude et le paramètre de modèle phase du signal de mesure étant calculés avec les valeurs échantillonnées à l'aide d'un modèle contenant au moins une composante sinusoïdale pour le signal de mesure et en utilisant un procédé récursif d'estimation des moindres carrés,
    **caractérisé par le fait que**

    -   on utilise un modèle constitué de la composante sinusoïdale pour le signal de mesure selon la relation y = A · sin (2πft + φ), y étant une valeur instantanée du modèle pour le signal de mesure, A l'amplitude, f la fréquence, φ l'angle de phase et t le temps, et
    -   avec ce modèle pour le signal de mesure et avec les valeurs échantillonnées, on détermine par l'estimation au moyen d'un procédé non linéaire et récursif d'estimation des moindres carrés, conjointement au paramètre de modèle amplitude (A) et au paramètre de modèle angle de phase (φ), le paramètre de modèle fréquence (f) du signal de mesure.

2.  Procédé selon la revendication 1,
    **caractérisé par le fait qu'**on utilise un modèle pour le signal de mesure selon la relation y = A · sin (2πft + φ) + d, d modélisant la composante continue du signal de mesure.

3.  Procédé selon la revendication 1,
    **caractérisé par le fait qu'**on utilise un modèle pour le signal de mesure selon la relation

$$y = A \cdot \sin\left(2\pi \sum_{i=0}^{n} (f^{(i)} t^{i}) t + \varphi\right),$$

$f^{(i)}$ étant la dérivée d'ordre i de la fréquence par rapport au temps et modélisant une variation de fréquence en fonction du temps et différents ordres de la dérivée de la fréquence par rapport au temps étant pris en compte par le choix de la grandeur n.

4. Procédé selon la revendication 2,
   **caractérisé par le fait qu'**on utilise un modèle pour le signal de mesure selon la relation

$$y = A \cdot \sin\left(2\pi \sum_{i=0}^{n} (f^{(i)} t^i)\, t + \varphi\right) + d,$$

$f^{(i)}$ étant la dérivée d'ordre i de la fréquence par rapport au temps et modélisant une variation de fréquence en fonction du temps et différents ordres de la dérivée de la fréquence par rapport au temps étant pris en compte par le choix de la grandeur n.

5. Procédé selon l'une des revendications 1 à 4,
   **caractérisé par le fait qu'**on ne délivre comme valeurs de résultat les valeurs, déterminées par le procédé d'estimation, de l'amplitude (A), de l'angle de phase ($\varphi$) et de la fréquence (f) que lorsque l'erreur d'estimation est inférieure à une erreur d'estimation minimale admissible.

Fig.1

Fig.2

Fig.3

Fig. 4

Fig. 5

t in ms